# EUROPÄISCHE PATENTSCHRIFT

(11) **EP 2 299 486 B1**
(45) Veröffentlichungstag und Bekanntmachung des Hinweises auf die Patenterteilung: **18.02.2015**
(21) Anmeldenummer: 09011911.6
(22) Anmeldetag: 18.09.2009
(51) Int. Cl.: H01L 21/56, H01L 23/31, H01L 21/683, H01L 25/00, H01L 23/00

(54) **Verfahren zum Bonden von Chips auf Wafer**
Method for bonding chips to wafers
Procédé de liaison de puces sur une tranche

(43) Veröffentlichungstag der Anmeldung: 23.03.2011
(73) Patentinhaber: EV Group E. Thallner GmbH, 4782 St. Florian am Inn (AT)
(72) Erfinder: Wimplinger, Markus, 4910 Ried im Innkreis (AT)
(74) Vertreter: Schweiger, Johannes

(56) Entgegenhaltungen:
- WO-A2-2008/098099
- JP-A- 2008 098 427
- US-A- 5 605 844
- US-A1- 2007 001 281
- US-A1- 2007 077 731
- US-B1- 6 492 196
- US-B1- 7 109 635

## Beschreibung

Die Erfindung betrifft ein Verfahren gemäß Patentanspruch 1.

Auf Grund des in der Halbleiterindustrie vorherrschenden Miniaturisierungsdrucks werden Verfahren benötigt, mit welchen sogenannte "3D Integrated Chips" (3D IC) hergestellt werden können. Die 3D ICs bestehen aus Chipstapeln, bei welchen mehrere Chips vertikal übereinander gestapelt sind und Verbindungen durch das Silizium hindurch zu den vertikal benachbarten Chips bestehen. Die Verbindungen werden als "Through Silicon Vias" (TSV) bezeichnet.

Von solchen Chips erwartet man sich eine höhere Packungsdichte sowie eine höhere Leistungsfähigkeit bei niedrigeren Kosten. Darüber hinaus können hierdurch neue Arten und Formen von Chips hergestellt werden. Für die Herstellung der 3D ICs kommen grundsätzlich verschiedene Verfahren in Frage, nämlich das sehr zeitaufwendige Stapeln einzelner Chips auf einzelne Chips, auch als "Chip to Chip" (C2C)-Verfahren bezeichnet oder das Stapeln von Wafer auf Wafer, auch als "Wafer to Wafer" (W2W)-Verfahren bezeichnet. Schließlich wird auch das sogenannte Chip auf Wafer-Verfahren, "Chip to Wafer" (C2W), diskutiert. Eine vernünftige technische Umsetzung ist bisweilen auf Grund erheblicher technischer Probleme nicht gelungen. Die vorliegende Erfindung bezieht sich auf ein technisch ausführbares C2W-Verfahren zur Herstellung von 3D ICs.

C2C-Verfahren verursachen auf Grund des niedrigen Durchsatzes höhere Produktionskosten und dürften in der Massenproduktion daher kaum Anwendung finden.

W2W-Verfahren erfordern, dass beide Wafer dieselbe Größe haben und dass die Chips auf beiden Wafern dieselbe Größe haben. Problem dabei ist es, dass die Silizium-Ausnutzung insbesondere bei höheren Chipstapeln unterdurchschnittlich ist (so genannter "Yield"). Auch die erreichbare Chipausbeute an funktionierenden Chips ist niedriger als bei C2C- oder C2W-Verfahren.

Technische Probleme bei der Umsetzung eines C2W-Verfahrens für die Herstellung von Chipstapeln beziehungsweise 3D ICs sind die Handhabung der Wafer, insbesondere mit darauf gestapelten Chips, sowie die unterschiedlichen Anforderungen, insbesondere Temperaturen, für den Stapelprozess und für die Connectoren (Schnittstellen) der Chips zur Montage auf Leiterplatten oder grundsätzlich der übergeordneten Packungseinheit.

Der Handhabung des Basiswafers kommt deshalb so große Bedeutung zu, weil ein Bruch des Basiswafers kurz vor dem Trennen der Vielzahl von Chipstapel auf dem Wafer zu einem Ausschuss von tausenden von teuren Chips führen würde. Die Handhabung des Basiswafers mit einer Vielzahl von darauf fixierten/gebondeten Chipstapeln wird umso schwieriger, je dünner und/oder großflächiger der Basiswafer ist. Als Basiswafer wird der Wafer bezeichnet, auf welchen die Chips im C2W-Verfahren gestapelt werden.

Die US2007/001281 A1 betrifft ein Verfahren zur Herstellung eines Halbleiterspeichers, bei dem zur Vereinfachung der Produktionslogistik bei der Herstellung von Speicherchips Chips auf einem Basiswafer gestapelt und anschließend in Harz gegossen werden. Nach dem Gießen werden die Speicherchips von Ihren benachbarten Speicherchips getrennt. Problematisch sind bei der Herstellung insbesondere unterschiedliche thermische Dehnungen der in den Chipstapeln vorhandenen verschiedenen Materialen der diversen Bauteile, vor allen Dingen beim Eingießen der Speicherchips sowie beim Lösen vom Träger und etwaigen, sich anschließenden Prozesschritten.

Die US 6 492 196 B1 und die WO 2008/098099 A2 befassen sich mit mechanischem Stress aufgrund verschiedener thermischer Ausdehnungskoeffizienten von angrenzenden Materialien bei Anwendung von Wärme in der Halbleitertechnologie.

Aufgabe der vorliegenden Erfindung ist es, ein möglichst ausschussfreies Verfahren zur Herstellung von möglichst exakt positionierten Chipstapeln (3D ICs) mit möglichst hohem Durchsatz anzugeben.

Diese Aufgabe wird mit den Merkmalen des Anspruchs 1 gelöst. Vorteilhafte Weiterbildungen der Erfindung sind in den Unteransprüchen angegeben.

Der Erfindung liegt der Gedanke zu Grunde, den Basiswafer zumindest während des Stapelns von Chips auf den Basiswafer und während der Wärmebehandlung der Chips zum Bonden den Wafer auf einem Träger zu fixieren oder mit einem Träger zu verbinden, und den Basiswafer spätestens vor der Wärmebehandlung zumindest teilweise zu vereinzeln, insbesondere in, vorzugsweise voneinander getrennte, Chipstapelabschnitte.

Durch die Fixierung des Basiswafers auf dem Träger wird es mit überraschendem Vorteil für den Durchsatz des C2W-Verfahrens möglich, die Verfahrensschritte des Stapelns beziehungsweise Platzierens der Chips in definierten Positionen auf dem Basiswafer und den/die Verfahrensschritte der Wärmebehandlung beziehungsweise des Bondens der Chips auf den Basiswafer zu trennen. Während die Wärmebehandlung beziehungsweise der Bondingschritt - je nach verwendetem Material - sehr lange dauern kann, ist die Positionierung beziehungsweise Stapelung und Platzierung der Chips auf dem Basiswafer ein Verfahrensschritt, der sehr zügig ablaufen kann, beispielsweise mit mehreren tausend Chips pro Stunde. Wenn der Basiswafer bei der Wärmebehandlung außerdem noch in kleinere Teile vereinzelt vorliegt, wirkt sich eine thermische Dehnung der unterschiedlichen Bauteile/Materialien deutlich weniger auf die Qualität der Chipstapel aus. Die Chipstapel werden auf Grund der Vereinzelung weniger durch die unterschiedlichen Ausdehnungen gestresst.

Hierdurch kann der Durchsatz erhöht werden, indem mehrere Wärmebehandlungskammern/Bondingstationen vorgesehen sind und/oder mehrere Basiswafer mit gestapelten Chips in einer Wärmebehandlungskammer/Bondingstation verarbeitet werden. Als Wärmebehandlungskammer kommen Hotplates, Durchlauföfen oder Ähnliches in Frage. Ein besonders vorteilhafter Prozess kann mit modifizierten Waferbondkammern realisiert werden, die es erlauben, während des Wärmebehandlungsprozesses Druck auf die Chips auszuüben.

Von besonderem Vorteil im Vergleich zu anderen Verfahren ist die Möglichkeit, dass beim vorliegenden Verfahren Chips unterschiedlicher Größe gestapelt werden können.

Durch die Verwendung eines nicht nur lose mit dem Basiswafer verbundenen Trägers können außerdem Spannungen oder Wölbungen des Basiswafers ausgeglichen werden beziehungsweise diesen entgegen gewirkt werden.

Die Handhabung wird noch weiter vereinfacht, indem der der Träger zumindest teilweise aus Silizium und/oder Glas besteht und im Wesentlichen der Größe des Basiswafers entspricht, insbesondere im Radius nicht mehr als 10 mm, insbesondere 5 mm, vorzugsweise 2mm, noch bevorzugter 1 mm von diesem abweicht.

Besonders bevorzugte Fixiermittel sind Unterdruck oder Vakuum, elektrostatische Mittel, mechanische Klemmung und/oder Kleber, wobei vorzugsweise hitzebeständiger Kleber verwendet wird, um auch bei hohen Temperaturen bei der Wärmebehandlung eine sichere Fixierung des Basiswafers auf dem Träger zu gewährleisten. Kombinationen unterschiedlicher Fixiermittel oder Effekte können dabei - je nach Art der herzustellenden Verbindung oder Höhe des Chipstapels oder wegen sonstiger Faktoren - zu einer weiter verbesserten Handhabung führen.

In einer bevorzugten Ausführungsform der Erfindung erfolgt die Ausrichtung und Kontaktierung von auf den vertikal benachbarten Chips aufgebrachten, elektrisch leitenden Plättchen unmittelbar beim Platzieren der Chips in definierten Positionen jeweils mit einer korrespondierenden, elektrisch leitenden Verbindung der darunter liegenden Lage von Chips.

Die Chipausbeute kann beim vorliegenden Verfahren mit Vorteil dadurch verbessert werden, dass beim Platzieren von Chips darauf geachtet wird, dass nur auf funktionierende Chips der darunter liegenden Lage Chips platziert werden. Noch bevorzugter wird die Funktion aller mit dem zu platzierenden Chip funktional verbundenen Chips geprüft und nur bei Funktion aller funktional mit dem Chip zu verbindenden Chips wird ein Chip platziert.

Bei der Wärmebehandlung beziehungsweise dem Bondingschritt werden die elektrisch leitfähigen Verbindungen zwischen den Wafer und dem darauf platzierten Chips beziehungsweise zwischen den platzierten Chips erzeugt. Dabei ist es von Vorteil, wenn das Aufheizen in einer geeigneten Atmosphäre stattfindet, die vorzugsweise frei von Sauerstoff ist, damit Oxidation der Metallkontaktflächen vermieden wird. Insbesondere ist dies durch den Einsatz von einer Stickstoffatmosphäre oder einer anderen inerten Atmosphäre, beispielsweise Argon, erreichbar, wobei für manche Anwendungen besonders vorteilhaft eine nicht nur inerte, sondern auch reduzierende Atmosphäre ist. Diese Eigenschaft kann zum Beispiel durch Formiergas oder Ameisensäuredampf erzielt werden. Formiergas kann dabei durch Mischung von H2 mit N2, insbesondere zwischen 2 % H2 zu 98 % N2 und 15 % H2 zu 85 % N2, gebildet werden. In dieser Mischung kann N2 auch durch andere inerte Gase ersetzt werden.

Damit die Chips nach dem Platzieren der Chips besser zu handhaben sind und nicht verrutschen, ist es von Vorteil, die Chips nach dem Platzieren vorzufixieren, insbesondere aufzukleben, vorzugsweise mit einem organischen Kleber, der während dem nachfolgenden Bondingschritt verdampft. Alternativ können die Chips durch eine molekulare Verbindung fixiert werden, die mit Vorteil spontan bei Raumtemperatur entsteht, beispielsweise zwischen Si-Flächen, SiO2-Flächen oder SiN-Flächen. Eine weitere Alternative stellt ultrasonic welding dar.

Mit Vorteil erfolgt die Wärmebehandlung, insbesondere durchgängig, bei einer Temperatur < 280°C, insbesondere < 250°C, vorzugsweise < 220°C. Die erfindungsgemäß eingesetzten Kleber müssen geeignet sein für die vorgenannten Temperaturen, wobei derartige Kleber erst seit kurzem überhaupt verfügbar sind. Beispiel für solche Kleber sind die der HAT-Serie von Brewer-Science Inc., USA.

Der Basiswafer hat in einer besonderen Ausgestaltung der Erfindung, insbesondere durch Rückdünnen, eine Dicke von weniger als 200 µm, insbesondere weniger als 100 µm, vorzugsweise weniger als 50 µm, noch bevorzugter weniger als 20 µm.

Besonders viele Chips finden auf einem Basiswafer mit einem Durchmesser von mindestens 200 mm, insbesondere mindestens 300 mm, vorzugsweise mindestens 450 mm Platz.

In einer besonderen Ausführungsform der Erfindung ist es erst durch die vorliegende Erfindung möglich, Lötperlen (sogenannte "solder bumps" oder "C4-bumps") nach dem Schritt b oder c zur Verbindung jedes Chipstapels mit einer Platine oder grundsätzlich der nächst übergeordneten Packungseinheit aufzubringen.

Die Lötperlen bestehen aus einer Metalllegierung mit niedrigem Schmelzpunkt und dienen generell der Verbindung der Chips/Chipstapel mit anderen elektrischen/elektronischen Bauteilen.

Insbesondere bei Verwendung eines Basiswafers mit den Basiswafer durchsetzenden elektrisch leitenden Verbindungen (TSVs) ist es von Vorteil, die Chips oder Chipstapel nach Schritt b oder c in eine, insbesondere durch hohe thermische und/oder mechanische Stabilität und/oder wasserabweisende Eigenschaften gekennzeichnete, Masse einzugießen, insbesondere eine Masse aus organischem und/oder aus keramischen Material. Besonders bevorzugt ist eine Ausführungsform, bei der zumindest teilweise Epoxidharz in der Masse enthalten ist beziehungsweise die Masse vollständig aus Epoxidharz gebildet ist. In einer besonderen Ausführungsform der Erfindung kann die Epoxidharz enthaltende Masse faserverstärkt sein.

Mit Vorteil wird die Masse in flüssiger Form bei Raumtemperatur oder bei höherer Temperatur eingegossen.

In einer vorteilhaften Ausführungsform der Erfindung wird die Masse nach dem Eingießen mit Druck beaufschlagt, insbesondere durch Entspannung auf Atmosphärendruck nach Durchführen des Eingießens unterhalb des Atmosphärendrucks, vorzugsweise im Vakuum. Hierdurch wird außerdem erreicht, dass etwaige Spalte und/oder Hohlräume mit der Masse gefüllt werden, was der Langzeitverlässlichkeit der Chipstapel zuträglich ist.

Durch die Wirkung der, vorzugsweise duroplastischen, Masse kann der Basiswafer mit Vorteil nach dem Eingießen vom Träger genommen werden.

Die Masse wird in einer bevorzugten Ausführungsform der Erfindung derart bearbeitet, dass die Masse nach dem Eingießen oder während des Eingießens in eine dem Basiswafer korrespondierende Grundform gebracht wird und/oder die Masse bis zur obersten Lage der Chips abgetragen, insbesondere abgeschliffen wird. Hierdurch wird die weitere Handhabung des aus Basiswafer, eingegossenen Chips und der Masse bestehenden Körpers weiter vereinfacht und es kann insbesondere auf bekannte Konstruktionen für die Handhabung zurückgegriffen werden. Durch das Abtragen der Masse kann mit Vorteil ein Kühlkörper auf die oberste Lage aufgebracht werden, indem eine präzise plane Oberfläche geschaffen wird.

Eine besonders bevorzugte Ausführungsform der Erfindung besteht darin, dass der Basiswafer und/oder der Träger aus Silizium bestehen, also der Träger ebenfalls ein Wafer ist. Dieser ist mit bekannten Konstruktionen handhabbar und hat den zusätzlichen Vorteil, dass der Wärmeausdehnungskoeffizient des Trägers, soweit Basiswafer und Träger aus Silizium bestehen, identisch ist.

Weitere Vorteile, Merkmale und Einzelheiten der Erfindung ergeben sich aus der nachfolgenden Beschreibung bevorzugter Ausführungsbeispiele sowie an Hand der Zeichnungen. Diese zeigen in:
- Fig. 1:: einen Aufbau einer Anlage zur Ausübung des erfindungsgemäßen Verfahrens,
- Fig. 2a:: eine schematische Darstellung eines erfindungsgemäßen Basiswafers,
- Fig. 2b:: eine schematische Darstellung eines erfindungsgemäßen temporären Bondingschritts,
- Fig. 2c:: eine schematische Darstellung eines erfindungsgemäßen Rückdünnschritts,
- Fig. 2d:: eine schematische Darstellung eines erfindungsgemäßen Schritts zur Ausbildung von elektrisch leitenden Verbindungen im Basiswafer,
- Fig. 2e:: eine schematische Darstellung eines erfindungsgemäßen Schritts der Rückseitenmetallisierung, insbesondere Aufbringung von elektrisch leitenden Plättchen auf die Oberfläche des Basiswafers,
- Fig. 2f:: eine schematische Darstellung eines erfindungsgemäßen Positionierschritts und Wärmebehandlungsschritts,
- Fig. 2g:: eine schematische Darstellung eines erfindungsgemäßen Eingießschritts,
- Fig. 2h:: eine schematische Darstellung eines erfindungsgemäßen Ablöseschritts zur Ablösung eines Trägers vom Basiswafer,
- Fig. 2i:: eine schematische Darstellung eines erfindungsgemäßen Reinigungsschritts,
- Fig. 2k:: eine schematische Darstellung eines erfindungsgemäßen Schritts zur Aufbringung von Lötperlen,
- Fig. 21:: eine schematische Darstellung eines erfindungsgemäßen Aufbringung auf einen Filmrahmen,

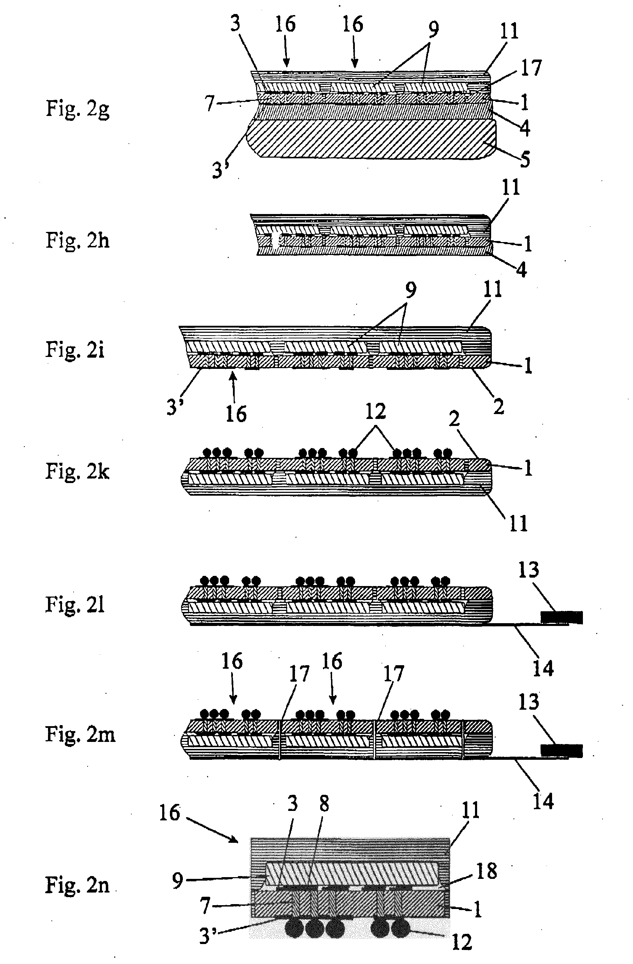

- Fig. 2m:: eine schematische Darstellung eines erfindungsgemäßen Trennschritts,
- Fig. 2n:: eine schematische Darstellung eines erfindungsgemäßen Chipstapels,

In den Figuren sind gleiche Bauteile und Bauteile mit der gleichen Funktion mit den gleichen Bezugszeichen gekennzeichnet.

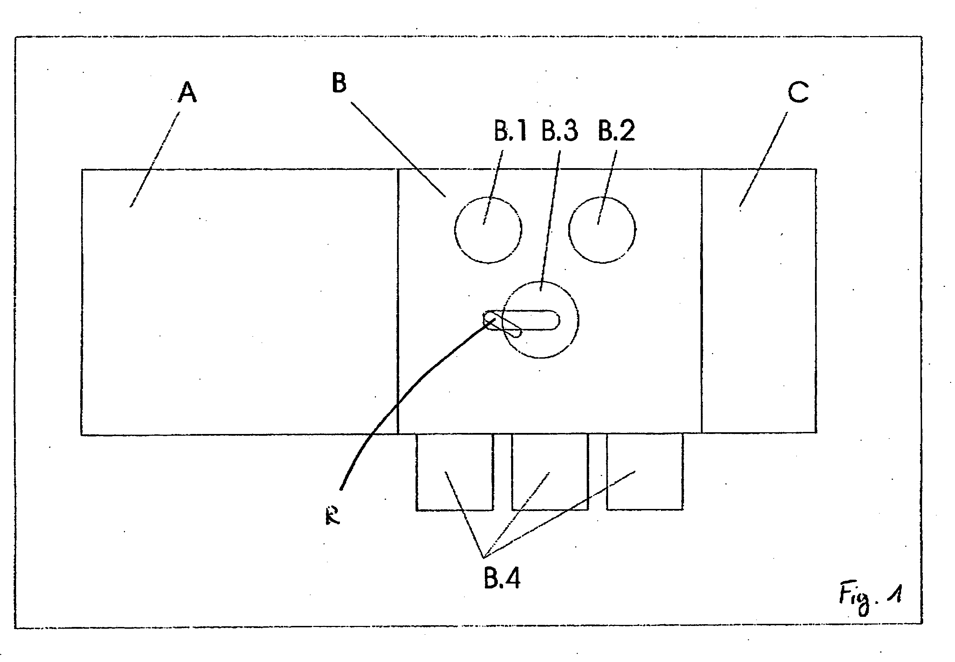

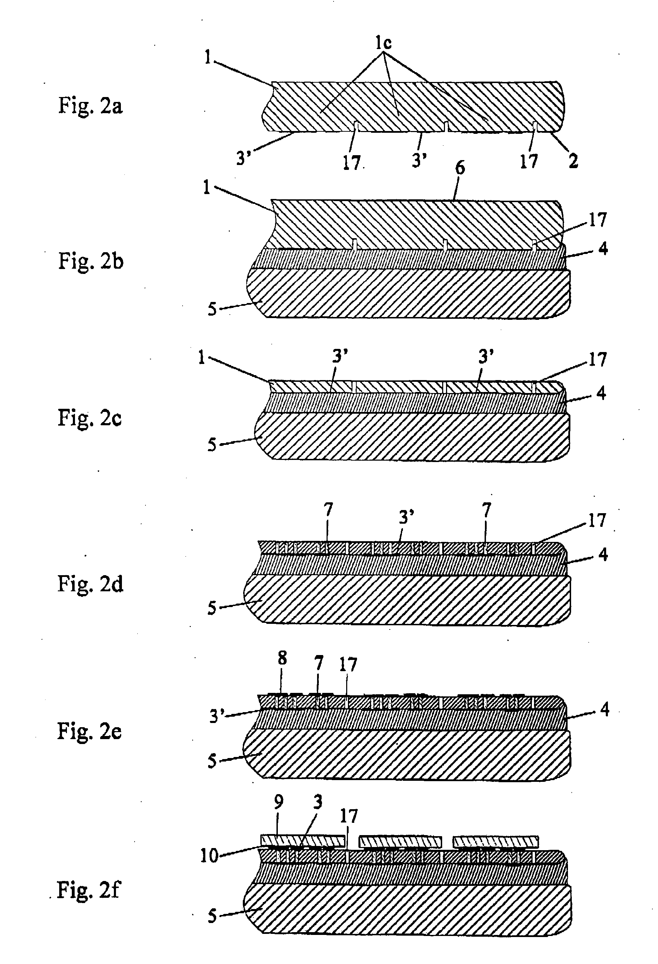

In Figur 1 ist ein schematischer Aufbau einer Anlage zur Ausführung des erfindungsgemäßen Verfahrens dargestellt, wobei im Bereich A die Platzierung von Chiplagen auf einem Basiswafer 1 gemäß Figur 2f stattfindet, nachdem der Basiswafer 1 auf einer Station B.1 oder anderweitig, beispielsweise vormontiert, auf einen Träger 5 montiert wurde und auf einer Folienabziehstation B.2 eine von einem vorherigen Rückdünnprozess vorhandene Rückdünnfolie (back grinding tape) abgezogen wurde.

Die Handhabung des Trägers 5 mit dem Basiswafer 1 erfolgt über einen Roboter B.3 mit einem Roboterarm R.

An dem Handhabungsmodul B ist eine Kassettenstation B.4 vorgesehen, von der die für das Verfahren zur Herstellung von Chipstapeln 16 notwendigen Materialien und/oder Bauteile entnommen werden beziehungsweise wieder abgegeben werden.

Nach Platzierung der Chips im Chipplatzierungssystem A wird der Träger 5 mit dem Basiswafer 1 und den auf dem Basiswafer 1 gestapelten Chips 3, 3', die gegebenenfalls über einen Kleber fixiert sind, zu der Bondingstation C zur Wärmebehandlung beziehungsweise zum Bonden der Chips auf den Basiswafer 1 geführt. Während der Wärmebehandlung beziehungsweise während des Bondens kann bereits der nächste Basiswafer 1 mit Chips 3, 3' bestückt werden. Die Bondingstation C kann auch aus mehreren Bondingeinheiten bestehen, da das Bonden - je nach Anforderungsprofil - insbesondere im Vergleich zum Platzieren der Chips erhebliche Zeit in Anspruch nehmen kann.

Weitere Behandlungsschritte mit auf dem Basiswafer 1 gebondeten Chipstapeln 16, wie beispielsweise die Trennung der Chipstapel 16 in einem Dicing-Modul sind in Figur 1 nicht dargestellt, können sich aber an die Bondingstation C anschließen oder vorzugsweise im Bereich des Handhabungsmoduls B, also in Figur 1 oberhalb des Handhabungsmoduls B angeordnet sein, damit die Handhabung der Chipstapel 16 über den Roboterarm R möglich ist. In einer bevorzugten Ausführungsform der Erfindung kann der Träger 5 auch im Dicing-Modul noch zum Einsatz kommen, wodurch die Chipstapel 16 auch nach dem Bonden mit dem Basiswafer 1 weiterhin sicher gehandhabt werden können.

In Figur 2a ist ein aus Silizium bestehender Basiswafer 1 dargestellt, dessen Vorderseite 2 durch vorherige Behandlungsschritte mit Chips 3' bestückt ist, die von der Oberfläche der Vorderseite 2 hervorstehen.

Durch in die Vorderseite 2 eingebrachte Vereinzelungsnuten 17 wird der Basiswafer 1 in Chipstapelabschnitte 1c unterteilt. Die Vereinzelungsnuten 17 erstrecken sich in vorteilhafter Weise nur über einen Teil der Dicke des Basiswafers 1, und zwar so weit, wie der Basiswafer in einem späteren Schritt von dessen Rückseite rückgedünnt wird.

Über Verbindungsmittel 4 wird der Basiswafer 1 gemäß Figur 2b mit dem Träger 5, hier ebenfalls einem aus Silizium bestehenden Wafer, verbunden, um von der Rückseite 6 des Basiswafers 1 her rückgedünnt werden zu können (siehe Figur 2c). Dabei wird der Basisiwafer 1 und damit die Chipstapelabschnitte 1c quasi automatisch beim Rückdünnen vereinzelt, wodurch spätere, insbesondere unterschiedliche, thermische Ausdehnungen auf die Qualität der Chipstapel einen wesentlich geringeren Einfluss haben.

Gemäß Figur 2d werden im Bereich jedes Chips 3' von der Rückseite 6 des Basiswafers 1 elektrische Verbindungen 7 hergestellt, die von der Rückseite 6 des Basiswafers 1 bis zum jeweiligen Chip 3' reichen.

Auf die Rückseite 6 des Basiswafers 1 werden zur elektrischen Kontaktierung weiterer Chips 3 elektrisch leitende Plättchen 8 auf die elektrisch leitenden Verbindungen 7 aufgebracht (siehe Figur 2e). In speziellen Ausführungsformen der Erfindung können die Chips 3 auch direkt mit den elektrisch leitfähigen Verbindungen 7 kontaktiert werden oder andere elektrisch leitende Anknüpfungspunkte hergestellt werden. Halterungen 9, insbesondere aus Silizium, dienen als Träger für die Chips 3.

Gemäß Figur 2f werden die Halterungen 9 mit deren Chipseite 10 auf die elektrisch leitenden Plättchen 8 aufgebracht, wobei die Schritte 2d bis 2f gegebenenfalls mehrfach wiederholt werden können, um eine Vielzahl von Halterungen 9 mit Chips 3 aufeinander zu stapeln und so die Chipstapel 16 aus mindestens zwei Lagen Chips 3, 3' zu bilden. Diese Prozessabfolge kann mit oder ohne Wärmebehandlungsschritt beziehungsweise Bondschritt zwischen den einzelnen Platzierungsschritten erfolgen. Die Platzierung der Halterungen 9 auf dem Basiswafer 1 erfolgt auf der Chipplatzierungsstation A.

Im Verfahrensschritt gemäß Figur 2g werden die Halterungen 9 mit Chips 3 beziehungsweise gegebenenfalls mehrere Lagen von Halterungen 9 in eine Masse 11 eingegossen, im vorliegenden Ausführungsbeispiel Epoxidharz. Wegen der erfindungsgemäßen vorherigen Vereinzelung vor dem Schritt des Gießens wirkt sich eine etwaige thermische Dehnung, insbesondere bei unterschiedlichen Wärmeausdehnungskoeffizienten der Materialen, wesentlich weniger aus.

Hohlräume 18, wie in Figur 2n deutlich zu sehen, können mit Vorteil durch geeignete Materialauswahl oder -paarung mittels Kapillarwirkung gefüllt werden, gegebenenfalls unterstützt durch eine Druckbeaufschlagung.

Nach dem Bonden der Chips 3, 3' und Aushärten der Masse 11 kann der Träger 5 entfernt werden, da durch die Masse 11 eine ausreichende Stabilisierung des dünnen und großflächigen Basiswafers 1 erfolgt. Das Ablösen des Trägers 5 kann automatisch durch Lösen des Verbindungsmittels 4 in dem Eingießschritt gemäß Figur 2g (hitzeabhängig) erfolgen. Weiterhin kann es vorteilhaft sein, den Ablöseschritt separat in einem nachgeschalteten Prozessschritt durchzuführen, wobei der Ablöseschritt entweder thermisch, chemisch oder durch Einwirkung einer externen Energiequelle (beispielsweise UV-Licht, Infrarotlicht, Laser oder Mikrowelle) ausgelöst werden kann.

In Figur 2h ist der Träger 5 abgelöst und in Figur 2i wird das Verbindungsmittel 4 entfernt, insbesondere durch Reinigung in einem Reinigungsschritt.

Im Verfahrensschritt gemäß Figur 2k ist der Basiswafer 1 zur Aufbringung von Lötperlen 12 auf die Chips 3' (siehe Figur 2i) gedreht worden, so dass die Vorderseite 2 nunmehr nach oben zeigt. Die Lötperlen 12 dienen dem späteren Anschluss der Chipstapel 16 (3D ICs) an Platinen oder die nächst übergeordnete Packungseinheit/Chiplage.

Als Material für die Verbindung zwischen den Chips 3, 3' kommt eine Reihe von Varianten in Frage. Grundsätzlich kann man zwischen metallischen Verbindungen, organischen Verbindungen, anorganischen Verbindungen und Hybridverbindungen unterscheiden. Im Bereich der metallischen Verbindungen kommen Metalldiffusionsverbindungen, eutektische Verbindungen, die während dem Bonden entstehen und Eutektika in Frage, die schon vor dem Bonden vorhanden waren und während des Bondens ermöglichen, die Legierung zu schmelzen. Letztere sind auch die Lötperlen 12, die in Form von Kugeln auf die Chips 3, 3' aufgebracht werden und das Herstellen der Verbindungen praktisch ohne Druckausübung ermöglichen. Es kommen auch leitfähige Polymere in Frage.

Im Verfahrensschritt gemäß Figur 2l wird der Basiswafer 1 mit den Chipstapeln 16 und Lötperlen 12 auf einer an einem Trennrahmen 13 (Dicing Frame) befestigten Folie 14 abgelegt, um anschließend gemäß Figur 2m die Chipstapel 16 voneinander zu trennen (Dicing). Die Trennung erfolgt im Bereich der Vereinzelungsnuten 17, insbesondere orthogonal zum Basiswafer 1. Als Resultat erhält man einen in Figur 2n dargestellten, vereinzelten Chipstapel 16 (3D IC), bestehend aus dem Chipstapelabschnitt 1c des Basiswafers 1 mit den Basiswafer 1 durchsetzenden elektrisch leitenden Verbindungen 7 (Vias), an den Vias angeschlossenen Chips 3, 3' sowie elektrisch leitenden Plättchen 8, an den Chips 3' angebrachten Lötperlen 12 und der Masse 11.

### Bezugszeichenliste

- A: Chipplatzierungsstation
- B: Handhabungsmodul
- B.1: Transferstation
- B.2: Folienabziehstation
- B.3: Roboter mit Roboterarm
- B.4: Kassettenstation
- C: Bondingstation
- R: Roboterarm
- 1: Basiswafer
- 1c: Chipstapelabschnitte
- 2: Vorderseite
- 3, 3': Chips
- 4: Verbindungsmittel
- 5: Träger
- 6: Rückseite
- 7: elektrisch leitende Verbindung
- 8: elektrisch leitende Plättchen
- 9: Halterungen
- 10: Chipseite
- 11: Masse
- 12: Lötperlen
- 13: Trennrahmen
- 14: Folie
- 16: Chipstapel
- 17: Vereinzelungsnuten
- 18: Hohlräume

## Patentansprüche

1. Verfahren zum Bonden einer Vielzahl von zu bondenden Chips (3) auf einen vorderseitig Chips (3') enthaltenden Basiswafer (1), wobei die zu bondenden Chips (3) in mindestens einer Lage auf dem Basiswafer (1) gestapelt werden und zwischen den vertikal benachbarten Chips (3, 3') elektrisch leitfähige Verbindungen (7) hergestellt werden, mit folgenden Schritten:
a) Fixieren des Basiswafers (1) auf einem Träger (5),
b) Platzieren mindestens einer Lage von zu bondenden Chips (3) in definierten Positionen auf dem Basiswafer (1) und
c) Wärmebehandlung zum Bonden der Chips (3) auf dem mit dem Träger (5) fixierten Basiswafer (1),
**dadurch gekennzeichnet, dass** vor Schritt c) eine Vereinzelung des Basiswafers (1) in getrennte Chipstapelabschnitte (1c) des Basiswafers (1) erfolgt.

2. Verfahren nach Anspruch 1, bei dem Schritt b) und c) in unterschiedlichen Geräten ausgeführt werden.

3. Verfahren nach einem der vorhergehenden Ansprüche, bei dem zum Fixieren Fixiermittel, insbesondere Vakuum, elektrostatische Mittel, mechanische Klemmung und/oder Kleber, vorzugsweise hitzebeständige Kleber, verwendet werden.

4. Verfahren nach einem der vorhergehenden Ansprüche, bei dem auf den Chips (3) aufgebrachte, elektrisch leitende Plättchen (8) beim Platzieren der Chips (3) in definierten Positionen jeweils mit einer korrespondierenden elektrisch leitenden Verbindung zum Anschluss einer darunter liegenden Lage von Chips (3, 3') ausgerichtet und kontaktiert werden.

5. Verfahren nach einem der vorhergehenden Ansprüche, bei dem die Chips (3) nach dem Platzieren aufgeklebt, vorzugsweise mit einem organischen Kleber, oder durch molekulare Verbindung fixiert werden.

6. Verfahren nach einem der vorhergehenden Ansprüche, bei dem die Chips (3, 3') oder Chipstapel (16) nach Schritt b) oder c) in eine, insbesondere durch hohe thermische und/oder mechanische und/oder chemische Stabilität und/oder wasserabweisende Eigenschaften gekennzeichnete, Masse (11) eingegossen werden, insbesondere aus organischem, vorzugsweise Epoxidharz, oder aus keramischem Material.

7. Verfahren nach Anspruch 6, bei dem der Basiswafer (1) nach dem Eingießen vom Träger (5) genommen wird.

8. Verfahren nach Anspruch 6 oder 7, bei dem der Basiswafer (1) mit der Masse (11) und den in der Masse (11) eingegossenen Chips (3) nach dem Eingießen oder während des Eingießens in eine dem Basiswafer (1) korrespondierende Grundform gebracht wird und/oder die Masse (11) bis zur obersten Lage der Chips (3) abgetragen, insbesondere abgeschliffen wird.

9. Verfahren nach einem der vorhergehenden Ansprüche, bei dem nach dem Schritt b) oder c), insbesondere nach dem Eingießen, Lötperlen (12) zur Verbindung jedes Chipstapels (16) mit einer Platine oder einem weiteren Chip (3) aufgebracht werden.

10. Verfahren nach einem der vorhergehenden Ansprüche, bei dem der Basiswafer (1) und/oder der Träger (5) zumindest überwiegend aus Silizium bestehen.

11. Verfahren nach einem der vorhergehenden Ansprüche, bei dem mindestens zwei Lagen Chips (3) auf den Basiswafer (1) aufgebracht werden.

12. Verfahren nach einem der Ansprüche 1 bis 5, bei dem die Chips (3) oder Chipstapel nach Schritt b) oder c) mit einer Masse (11), insbesondere einem thermoplastischen Material, heißgeprägt werden.

13. Verfahren nach einem der vorhergehenden Ansprüche, bei dem der Basiswafer (1) mit den darauf gestapelten Chips (3) auf einem Trennrahmen (13) fixiert wird, bevor eine Trennung der Chipstapel (16) von benachbarten Chipstapeln (16) erfolgt.

14. Verfahren nach einem der vorhergehenden Ansprüche, bei dem der Basiswafer (1) beim Rückdünnen vereinzelt wird.

## Claims

1. Method for bonding of plurality of bonding chips (3) onto a base wafer (1) which contains chips (3') on its front side, the bonding chips (3) being stacked in at least one layer on the base wafer (1), and electrically conductive connections (7) are established between vertical adjacent chips (3, 3'), with the following steps:
a) fixing of the base wafer (1) on a carrier (5),
b) placing at least one layer of bonding chips (3) in defined positions on the base wafer (1), and
c) heat treatment for bonding of the chips (3, 3') on the base wafer (1) fixed on the carrier (5),
**characterized in that** prior to step c) a separation of the base wafer (1) into separated chip stack sections (1c) of the base wafer (1) takes place.

2. Method as claimed in claim 1, wherein step b) and c) are carried out in different devices.

3. Method as claimed in one of the preceding claims, wherein fixing means are used for fixing, especially a vacuum, electrostatic means, mechanical clamping and/or adhesives, preferably heat-resistant adhesives.

4. Method as claimed in one of the preceding claims, wherein electrically conductive laminae applied to the chips (3) in the placement of the chips (3) in defined positions are aligned and bonded to a corresponding electrically conductive laminae for connection of the underlying layer of chips (3, 3'):

5. Method as claimed in one of the preceding claims, wherein the chips (3) after placement are adhered, preferably with an organic adhesive, or by molecular connection.

6. Method as claimed in one of the preceding claims, wherein the chips (3, 3') or chip stacks (16) after step b) or c) are potted in a mass (11) which is characterized especially by high thermal and/or mechanical and/or chemical stability and/or water-repellent properties, especially of organic material, preferably epoxy resin, or of ceramic material.

7. Method as claimed in claim 6, wherein the base wafer (1) is removed from the carrier (5) after potting.

8. Method as claimed in claim 6 or 7, wherein the base wafer (1) with the mass (11) and the chips (3) potted in the mass (11) after potting or during potting is brought into the basic form corresponding to the base wafer (1) and/or the mass (11) is removed as far as the uppermost layer of the chips (3), especially is ground off.

9. Method as claimed in one of the preceding claims, wherein after step b) or c), especially after potting, solder bumps (12) are applied for connection of each chip stack (16) to a board or another chip (3).

10. Method as claimed in one of the preceding claims, wherein the base wafer (1) and/or the carrier (5) consist at least predominantly of silicon.

11. Method as claimed in one of the preceding claims, wherein at least two layers of chips (3) are applied to the base wafer (1).

12. Method as claimed in one of claims 1 to 5, wherein the chips (3) or chip stacks after step b) or c) are hot-embossed with a mass (11), especially a thermoplastic material.

13. Method as claimed in one of the preceding claims, wherein the base wafer (1) with the chips (3) stacked on it is fired on a dicing frame (13) before the chip stack (16) is separated from adjacent chip stacks (16).

14. Method as claimed in one of the preceding claims, wherein the base wafer (1) is separated during back-grinding.

## Revendications

1. Procédé pour la liaison d'une pluralité de puces (3) à lier sur une tranche de base (1) contenant des puces (3') sur une face avant, les puces (3) à lier étant empilées en au moins une couche sur la tranche de base (1) et des connexions électro-conductrices (7) étant réalisées entre les puces (3, 3') verticalement adjacentes, avec les étapes suivantes :
a) fixation de la tranche de base (1) sur un support (5),
b) mise en place d'au moins une couche de puces (3) à lier dans des positions définies sur la tranche de base (1) et
c) traitement thermique pour la liaison des puces (3, 3') sur la tranche de base (1) fixée avec le support (5).
**caractérisé en ce que**, avant l'étape c), on effectue une séparation de la tranche de base (1) en sections de piles de puces (1c) séparées de la tranche de base (1).

2. Procédé selon la revendication 1, dans lequel les étapes b) et c) sont réalisées dans des appareils différents.

3. Procédé selon l'une des revendications précédentes, dans lequel on utilise, pour la fixation, des moyens de fixation, en particulier du vide, des moyens électrostatiques, un serrage mécanique et/ou des adhésifs, de préférence des adhésifs résistant à la chaleur.

4. Procédé selon l'une des revendications précédentes, dans lequel des plaquettes électro-conductrices appliquées sur les puces (3), lors du placement des puces (3) dans des positions définies, sont respectivement orientées et mises en contact avec une des plaquettes électro-conductrices correspondante pour le raccordement d'une couche de puces (3, 3') située en-dessous.

5. Procédé selon l'une des revendications précédentes, dans lequel, après le placement, les puces (3) sont collées, de préférence avec un adhésif organique, ou sont fixées grâce à une liaison moléculaire.

6. Procédé selon l'une des revendications précédentes, dans lequel après l'étape b) ou c), les puces (3, 3') ou piles de puces (16) sont coulées dans une masse (11) se caractérisant en particulier par une stabilité thermique et/ou mécanique et/chimique élevée et/ou des propriétés hydrofuges, en particulier en un matériau organique, de préférence une résine époxy ou en un matériau de céramique.

7. Procédé selon la revendication 6, dans lequel, après le coulage, la tranche de base (1) est retirée du support (5).

8. Procédé selon la revendication 6 ou 7, dans lequel, après le coulage ou pendant le coulage, on confère à la tranche de base (1) avec la masse (11) et les puces (3) coulées dans la masse (11) une forme de base correspondant à la tranche de base (1) et/ou la masse (11) étant enlevée, en particulier rectifiée jusqu'à la couche la plus élevée des puces (3).

9. Procédé selon l'une des revendications précédentes, dans lequel, après l'étape b) ou c), en particulier après le coulage, des perles de soudure (12) sont appliquées pour relier chaque pile de puces (16) à une carte ou une autre puce (3).

10. Procédé selon l'une des revendications précédentes, dans lequel la tranche de base (1) et/ou le support (5) se composent au moins essentiellement de silicium.

11. Procédé selon l'une des revendications précédentes, dans lequel au moins deux couches de puces (3) sont appliquées sur la tranche de base (1).

12. Procédé selon l'une des revendications 1 à 5, dans lequel les puces (3) ou piles de puces, après l'étape b) ou c), sont estampées à chaud avec une masse (11), en particulier un matériau thermoplastique.

13. Procédé selon l'une des revendications précédentes, dans lequel la tranche de base (1) avec les puces (3) empilées dessus est fixée sur un cadre de séparation (13) avant qu'une séparation des piles de puces (16) de piles de puces (16) voisines soit effectuée.

14. Procédé selon l'une des revendications précédentes, dans lequel la tranche de base (1) est séparée lors de l'amincissement.
